# EUROPEAN PATENT APPLICATION

(11) **EP 0 765 037 A2**
(43) Date of publication of application: **26.03.1997**
(21) Application number: 96114778.2
(22) Date of filing: 11.09.1996
(51) Int. Cl.: H03K 19/0185, H03K 19/003

(54) **Buffer for integrated circuit memories**

(30) Priority: 20.09.1995 US 531266
(71) Applicant: TEXAS INSTRUMENTS INCORPORATED, Dallas, Texas 75243 (US)
(72) Inventor: Coots, Timothy J., The Woodlands, TX 77381 (US); Truong, Phat C., Houston, TX 77083 (US); Lin, Sung-Wei, Houston, TX 77083 (US); Coffman, Tim M., Sugar Land, TX 77478 (US); Robinson, Dennis R., Needville, TX 77461 (US); Syzdek, Ronald J., Sugar Land, TX 77479 (US)
(74) Representative: Holt, Michael

(57) **Abstract**

The circuit of this invention includes a current-compensated output buffer (OBC) that decreases the output switching rate as the conditions for transient noise increase to provide operation at maximum speed during worst-case speed conditions while suppressing noise during worst-case noise conditions. Transistors (M35-M42) in the output pre-driver stages (15,16) are used to limit the output-stage (14) charge and discharge rate. These limiting pre-driver transistors (M35-M42) are controlled by a supply-voltage (V_{CC}) and temperature compensating circuit (BGC). Compensating circuit (BGC) includes long channel transistors configured to increase a reference current (I_{REF}) with temperature and to decrease that reference current (I_{REF}) with increase in supply voltage (V_{CC}), the compensating circuit (BGC) providing biasing currents (I_{REFN} and I_{REFP}) to output stage (14).

## Description

### BACKGROUND OF THE INVENTION

The present invention relates to integrated-circuit memories, including non-volatile memories and Dynamic Random Access Memories (DRAMs). More particularly, this invention relates to buffer circuitry for use in such memory devices, the buffer circuitry designed to compensate for temperature and supply voltage variations to achieve improved speed and noise performance.

Under certain circumstances, the operating speed of CMOS buffers is limited by the worst-case speed conditions, which are a low supply voltage and a high temperature. However, when CMOS buffer circuitry is exposed to conditions of high supply voltage and low temperature, the speed increases from the speed set using worst-case speed conditions of low supply voltage and high temperature.

Under other circumstances, the operating speed of CMOS buffers is limited by the worst-case noise conditions, which are a high supply voltage and a low temperature. The latter conditions tend to produce excessive transient noise, especially when multiple buffers on the chip switch simultaneously. Operation of a buffer at higher data-transfer speed tends to increase the transient noise problem.

In the prior-art, it is often necessary to set the speed to an even lower rate than that allowable under worst-case speed conditions in order to decrease transient noise to acceptable levels.

One method for controlling switching noise is the use of resistors in the pre-driver stages to lower speed of operation of buffer circuitry. That method includes use of source and/or drain side resistors on the pre-driver output stage. The side resistors limit the switching rate of the output stage. Other examples of other compensation circuits are described in U.S. Patent No. 4,975,598 issued December 4, 1990, entitled TEMPERATURE, VOLTAGE, AND PROCESS COMPENSATED OUTPUT DRIVER; U.S. Patent No. 4,978,905 issued December 18, 1990, entitled NOISE REDUCTION OUTPUT BUFFER; and U.S. Patent No. 5,021,684 issued June 4, 1991 entitled PROCESS, SUPPLY, TEMPERATURE COMPENSATING CMOS OUTPUT BUFFER.

There is a need for an alternative buffer circuit that overcomes the problems described above, allowing operation at maximum speed during worst-case speed conditions while suppressing noise during worst-case noise conditions.

### SUMMARY OF THE INVENTION

The circuit of this invention overcomes these problems by utilizing a current-compensated output buffer that decreases the output switching rate as the conditions for transient noise increase. Thus, the output buffer of this invention operates at maximum speed during worst-case speed conditions and noise is suppressed during worst-case noise conditions.

The temperature and supply-voltage compensated output buffer of this invention uses transistors in the output pre-driver stage to limit the output-stage charge and discharge rate. These limiting pre-driver transistors are controlled by a supply-voltage and temperature compensating circuit that includes long-channel transistors with temperature-sensitive resistance.

### BRIEF DESCRIPTION OF THE DRAWINGS

The present invention will now be further described, by way of example, with reference to the accompanying drawings in which:
FIG. 1 is a schematic diagram of the supply-voltage V_{CC} and temperature compensating circuit of the invention;
FIG. 2 is a schematic diagram of the output buffer of the invention, including the pre-driver and output stages; and
FIG. 3 is a graph illustrating how the P-channel pre-driver current and the N-channel pre-driver current increase with increasing temperature and decrease with increasing supply voltage V_{CC}.

### DETAILED DESCRIPTION OF THE INVENTION

In conventional output buffers, speeds are normally faster, but noisier, in low-temperature/high-supply-voltage environments. The bias generator circuit of this invention is designed to control the gates of drivers of output buffers such that the noise created by output drivers in low-temperature/high-supply-voltage environments is reduced.

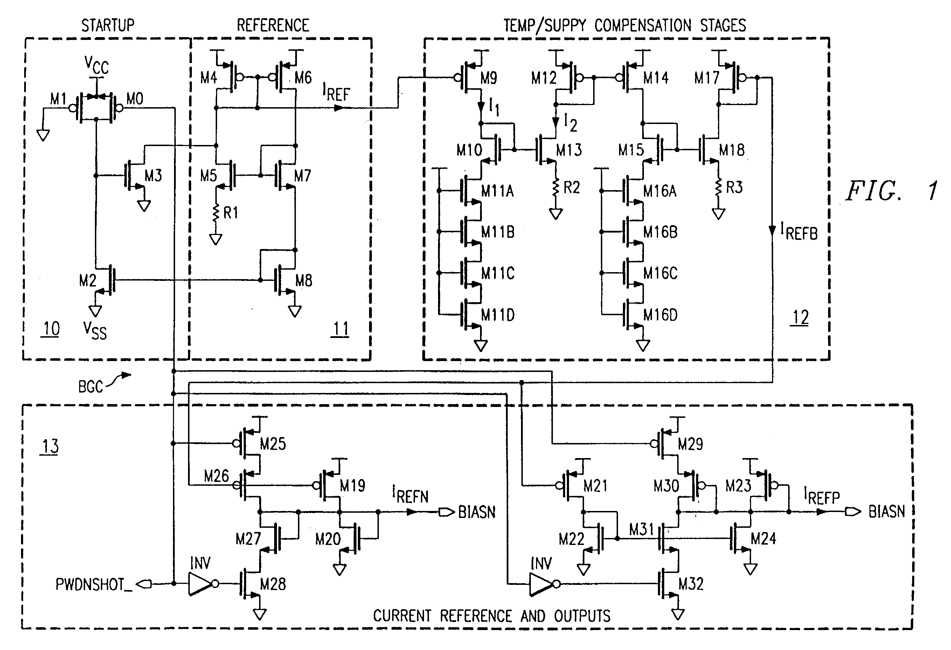

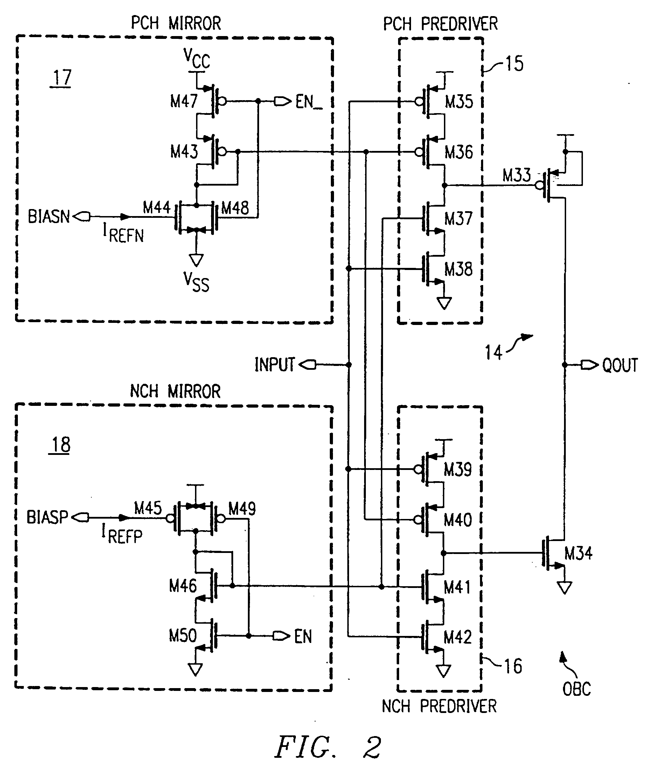

The bias generator circuit BGC of FIG. 1 provides two bias currents, I_{REFP} and I_{REFN} at terminals BIASP and BIASN. These bias currents I_{REFP} and I_{REFN} control the current in the pre-driver circuits of the output stage of the buffer circuit of FIG. 2. Using these supply-voltage V_{CC} and temperature compensated bias currents I_{REFP} and I_{REFN}, the speed of the output buffer of FIG. 2 is optimized over a wider range of conditions while the transient noise is reduced. Noise problems predominate when the temperature is low and the supply voltage V_{CC} is high. However, speed is typically optimized at high temperature and low supply voltage V_{CC}. The bias generator circuit BGC is used to compensate for noise and speed of the output buffer, which is described later in conjunction with the description of the circuit of FIG. 2.

The bias generator circuit BGC of FIG. 1 consists of a start-up stage 10, a reference stage 11, two temperature/supply-voltage V_{CC} compensation stages 12, and trimming and output stages 13.

To provide proper operation after the supply-voltage V_{CC} ramp during power-up, transistors M0-M3 of start-up stage 10 initialize the reference stage 11. The channel length-to-width ratios of transistors M0, M1, M2 and M3 are, for example, 3-to-4, 3-to-38, 1.2-to-80 and 15-to-0.9, respectively. After initialization, an initial reference current I_{REF} establishes and, by feedback, turns off the start-up circuit 10. The reference stage 11 includes transistors M4-M8 and resistor R1. Transistors M4-M8 and resistor R1 are sized to accommodate a desired initial reference current I_{REF} while at the same time realizing a manageable layout. The channel length-to-width ratios of transistors M4, M5, M6, M7 and M8 are, for example, 2-to-10, 1.2-to-30, 2-to-10, 1.2-to-30 and 1.2-to-30, respectively. Resistor R1 is, for example, 30,000 ohms. The initial reference current I_{REF} may vary about 6% over the supply-voltage V_{CC} range and about 12% over the temperature range. Typically, the initial reference current I_{REF} increases with increasing supply voltage V_{CC} and decreasing temperature. However, the compensation stages 12 act to convert the initial reference current I_{REF} to supply a decreased reference bias current I_{REFB} that compensates for the increase in initial reference current I_{REF} with increasing supply voltage V_{CC} and decreasing temperature. Compensation stages 12 include two stages comprising transistors M9-M18 and resistors R2-R3. The channel length-to-width ratios of transistors M9, M10, M11A-M11D, M12, M13, M14, M15, M16A-M16D, M17 and M18 are, for example, 2-to-10, 1.2-to-30, 6-to-10 (each), 2-to-10, 1.2-to-30, 2-to-10, 1.2-to-30, 6-to-10 (each), 2-to-10 and 1.2-to-30, respectively. Resistors R2 and R3 are, for example, 30,000 ohms and 15,000 ohms, respectively. These two stages provide, by mirror, a reference bias current I_{REFB} that compensates for supply voltage V_{CC} and temperature variations through the series of long-channel, N-channel transistors M11A-M11D and M16A-M16D, each operating in the saturation region. This compensated reference bias current I_{REFB} is coupled to the two output stages 13, which generate bias currents I_{REFN} and I_{REFP} at terminals BIASN and BIASP, respectively. The output stages comprise transistors M19-M32 of FIG. 1. The channel length-to-width ratios of transistors M19-M24 are, for example, 2-to-10 (each). The channel length-to-width ratios of transistors M25, M26, M27, M28, M29, M30, M31 and M32 are, for example, 0.9-to-45, 2-to-20, 2-to-20, 0.9-to-30, 0.9-to-30, 2-to-30, 2-to-30 and 0.9-to-30, respectively. The bias current I_{REFN} at the BIASP terminal affects the pull-up stage of the output buffer while the bias current I_{REFN} at the BIASN terminal affects the pull-down stage of the output buffer. At low temperature and high supply voltage V_{CC}, when speed is not a problem but noise is, the current in the pre-driver stages of the output buffer is limited and output switching is slowed, thus reducing noise. At high temperature and low supply voltage V_{CC}, speed is slowest and noise is minimal. Therefore, the bias levels of currents I_{REFP} and I_{REFN} allow a maximum pre-driver current, such that the overall output buffer speed is maximized.

In an example application, the output of the bias generator circuit BGC of FIG. 1 controls sixteen output buffer circuits, such as the circuit described in FIG. 2. During power-down, the bias currents I_{REFP} and I_{REFN} are pulled to ground V_{SS} and supply voltage V_{CC} rails, respectively, to eliminate unnecessary current draw. Routing and gate capacitances at the BIASP and BIASN terminals are large and the time required for the bias currents I_{REFP} and I_{REFN} to switch during power-up to proper bias levels is ordinarily too long. To alleviate this problem, transistors are connected in parallel with each output mirror to effectively create a stronger mirror capable of rapid switching of the high capacitive node. These parallel mirrors are turned ON via a signal at the PWDNSHOT_ terminal during power-up for a short period of time and are turned OFF after bias levels of currents I_{REFP} and I_{REFN} are established.

Referring now to FIG. 2, output buffer circuit OBC typically drives a large off-chip load, accomplishing this with a large on-chip driving stage 14 comprising transistors M33-M34. The channel length-to-width ratios of transistors M33 and M34 are, for example, 1.8-to-800 and 1.8-to-600, respectively. The transient noise produced by multiple output drivers M33-M34 switching is undesirable and is at its worst when operation is at high supply voltage V_{CC} and low temperature. The circuit of FIG. 2 illustrates current-controlled pre-drivers 15 and 16 and an output stage 14. When coupled with the supply voltage V_{CC} and temperature-compensating bias generator circuit BGC of FIG. 1, the circuit of FIG. 2 reduces transient noise at high supply voltage V_{CC} and/or low temperature but, at the same time, allows for faster output switching speed at low supply voltage V_{CC} and/or high temperature.

The input to the pre-driver stage is indicative of data at the output stage. There are two pre-driver stages in the circuit of FIG. 2.

The P-channel pre-driver subcircuit 15 includes transistors M35-M38. The channel length-to-width ratios of transistors M35, M36, M37 and M38 are, for example, 0.9-to-40, 1-to-40, 2-to-80 and 0.9-to-80, respectively. The output of the P-channel pre-driver subcircuit 15 controls the gate of transistor M33, which is the pull-up transistor of the output stage 14. Transistors M35 and M38, with transistors M36 and M37 connected to their drains, respectively, provide the inverting-gain stage of the pre-driver subcircuit 15. Transistor M37 is a current-limited transistor, controlling the turn-ON rate of output driver transistor M33. The current through transistor M37 is from a local mirror stage that, in turn, is a mirror of the supply-voltage V_{CC} and temperature compensated current. Transistor M36 similarly controls the turn-OFF rate of transistor M33. Transistor M36 is sized so that the turn-OFF rate of transistor M33 is slightly faster than the turn-ON rate of transistor M34. This tends to minimize the overlap current associated when both transistors M33 and M34 are momentarily ON.

Similarly, the N-channel pre-driver subcircuit 16 includes transistors M39-M42. The channel length-to-width ratios of transistors M39, M40, M41 and M42 are, for example, 0.9-to-40, 2-to-40, 1-to-80 and 0.9-to-20, respectively. The output of the N-channel pre-driver subcircuit controls the gate of transistor M34, which is the pull-down device of the output stage 14. Transistors M39 and M42, with transistors M40 and M41 connected to their drains, respectively, provide the inverting gain stage of the pre-driver subcircuit 16. Transistor M40 is a current-limited transistor, which controls the turn-ON rate of the output driver transistor M34. The current through transistor M40 is from a local mirror stage that, in turn, is a mirror of the supply-voltage V_{CC} and temperature compensated current. Transistor M41 similarly controls the turn-OFF rate of transistor M34. Transistor M41 is sized so that the turn-OFF rate of transistor M34 is slightly faster than the turn-ON rate of transistor M33. This tends to minimize the overlap current associated when both transistors M33 and M34 are momentarily ON.

The bias currents for transistors M40 and M37 are locally mirrored from a P-channel mirror 17 and a N-channel mirror 18, respectively. P-channel transistors M43 and M44 comprise the P-channel mirror stage 17 that controls the pull-up characteristics of the output stage 14. The channel length-to-width ratios for transistors M43 and M44 are, for example, 2-to-10 and 2-to-60, respectively. N-channel transistors M45 and M46 comprise the N-channel mirror stage 18 that controls the pull-down characteristics of the output stage 14. The channel length-to-width ratios of transistors M45 and M46 are, for example, 2-to-60 and 2-to-10, respectively. These mirror stages 17 and 18 are sized for optimum current gain and provide local buffering and control over bias levels. The inputs to the mirror stages 17 and 18 are the two supply-voltage-compensated and temperature-compensated bias currents, I_{REFP} and I_{REFN} at terminals BIASN and BIASP, respectively, which are perhaps global for all output buffers. Signals EN and EN_ provide disablement of the mirror stages 17 and 18 during low-power, or sleep, mode of operation.

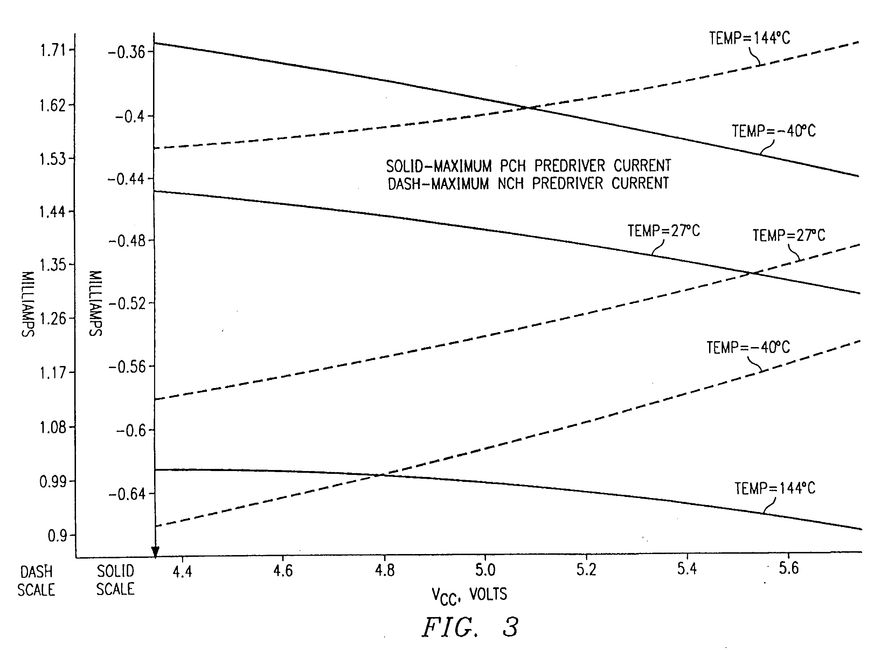

Referring now to FIG. 3, a graph illustrates how the P-channel pre-driver current and the N-channel pre-driver current increase with increasing temperature and decrease with increasing supply voltage V_{CC}.

Referring again to FIG. 1, temperature compensation is accomplished through the compensation stages illustrated therein. A initial reference current I_{REF} is supplied by the reference circuit. The initial reference current I_{REF} is mirrored to the circuit of the first compensation stage, which consists of transistors M9-M11D. Because transistors M4 and M9 are matched, a similar current I₁ is imposed through this first compensation stage. An increase in temperature causes an increase in the "turn-ON" resistance of the saturated long-channel transistors M11A-M11D. This, in turn, causes the gate-to-source voltage plus the voltage drop [Vgs(M10)+V(M11)] across transistors M11 to increase also. The current I₁ is mirrored to the second compensation stage consisting of transistors M12 and M13 and resistor R2. To maintain the same voltage [Vgs(M13)+V(R2)] as the voltage [Vgs(M10)+V(M11)] of the first compensation stage, the current designated I₂ in this stage must increase. These two compensation stages are repeated again to achieve sufficient compensation for temperature variation. Therefore, as the temperature increases, the mirrored reference bias current I_{REFB} at the output increases.

Most of the compensation for variations in supply voltage V_{CC} comes from the reference portion of the bias circuit. As supply voltage V_{CC} increases, the initial reference current I_{REF} also increases to maintain the open-loop gain at unity. Therefore, as the supply voltage V_{CC} increases, the initial reference current I_{REF} to first stage of the compensation circuits also increases and the "turn-ON" resistance of the saturated long-channel transistors decreases. In a similar manner as temperature compensation, the second stage current tracks the [Vgs(M13)+V(R2)] voltage drop. As the supply voltage V_{CC} increases, [Vgs(M13)+V(R2)] decreases and the mirrored current decreases. However, complete compensation for a supply-voltage V_{CC} variation of +/- 15% is reduced to a +/-10% drive current variation. Total elimination of supply-voltage V_{CC} variation is not desirable because the CMOS output switching time is referenced as a percentage of the supply voltage V_{CC}.

In summary, the bias generator circuit BGC described in FIG. 1 has supply-voltage V_{CC} and temperature compensation stages. The first and second bias current outputs I_{REFP} and I_{REFN} of the bias generator circuit BGC are used as the inputs to the first and second output buffer pre-driver stages 15 and 16, respectively. Depending on the temperature and/or supply voltage V_{CC} of the circuit, the switching rate of the output stage 14 is allowed to 1) swing at full potential for faster speed or 2) is limited during switching to suppress noise.

This invention features a bias generator circuit BGC comprising:
a) a start-up stage 10;
b) a reference stage 11;
c) two supply-voltage V_{CC} and temperature compensation stages 12; and
d) output and trimming stages 13.
and an output buffer circuit OBC comprising:
a) two current-limiting pre-driver stages 15 and 16;
b) two current-mirror stages 17 and 18 with enable functions; and
c) an output stage 14.

While this invention has been described with respect to an illustrative embodiment, this description is not intended to be construed in a limiting sense. Upon reference to this description, various modifications of the illustrative embodiment, as well as other embodiments of the invention, will be apparent to persons skilled in the art.

## Claims

1. A output buffer comprising:
an output stage having first and second output-stage signal inputs; and
first and second pre-driver stages having first and second pre-driver outputs coupled to associated first and second output-stage inputs, the first and the second pre-driver stages further having first and second pre-driver signal inputs and having first and second pre-driver speed control inputs;
said first and second pre-driver speed control inputs respectively being coupled to first and second bias currents the magnitude of said first and second bias currents increasing with the temperature of long-channel transistors.

2. The output buffer of Claim 1, further comprising a compensation circuit that includes said long-channel transistors, wherein said first and second bias currents are mirrored from a reference bias current furnished by said compensation circuit.

3. The output buffer of Claim 1 or Claim 2, wherein said long-channel transistors cause said first and second bias current to vary from a reference current.

4. The output buffer of any of Claims 1 to 3, wherein said long-channel transistors cause said first and second bias currents to vary from an initial reference current and wherein said initial reference current increases with increase in supply voltage.

5. The output buffer of Claim 4, wherein said long-channel transistors cause said first and second bias currents to decrease in magnitude with increase in supply voltage.

6. The output buffer of any of Claims 1 to 5, wherein said first and second bias currents are mirrored to pre-driver stages of at least a second output buffer.

7. The output buffer of any preceding claim, wherein said first and second bias currents are supply-voltage sensitive.

8. The output buffer of any preceding claim, wherein said first and second bias currents cause the speed of said output buffer to decrease at higher temperature.

9. The output buffer of any preceding claim, wherein the source-drain paths of a plurality of said long-channel transistors are connected in series and wherein each of the gates of said serially connected long-channel transistors is connected to a power supply.

10. The output buffer of any preceding claim, wherein each of said serially connected long-channel transistors has a length-to-width ratio of 6-to-10.

11. The output buffer of any preceding claim, wherein said first and second bias currents increase with the temperature of two multiplication stages of said long-channel transistors.

12. An output buffer circuit for an integrated circuit, said output buffer circuit comprising:
an output circuit having first and second bias inputs;
a bias generator circuit having first and second bias outputs coupled to said first and second bias inputs, respectively;
said bias generator circuit further comprising:
a reference circuit supplying an initial reference current; and
a compensating circuit with first and second output circuits, said compensating circuit receiving said initial reference current and converting said initial reference current to a reference bias current, said reference bias current furnished to said first and second output circuits, said first and second output circuits converting said reference bias current to first and second bias currents, said first and second bias currents supplied at said first and second bias outputs of said bias generator circuit, respectively;
said compensating circuit including long-channel transistors, each long-channel transistor having a resistance sensitive to temperature change, said long-channel transistors connected to increase said first and second bias currents in response to increase in temperature.

13. The output buffer circuit of Claim 12, wherein the source-drain paths of a plurality of said long-channel transistors are connected in series and wherein each of the gates of said serially connected long-channel transistors is connected to a power supply.

14. The output buffer circuit of claim 12 or Claim 13, wherein the reference circuit supplies an initial reference current that increases with supply voltage.

15. The output buffer circuit of Claim 14, wherein the long-channel transistors are connected to decrease the first and second bias currents in response to an increase in the supply voltage.
